# EUROPEAN PATENT APPLICATION

(11) **EP 4 629 555 A1**
(43) Date of publication of application: **08.10.2025**
(21) Application number: 23915741.5
(22) Date of filing: 05.12.2023
(51) Int. Cl.: H04L 7/00, H04L 1/00

(54) **ALIGNMENT MARKER SEARCH METHOD, APPARATUS AND SYSTEM, AND COMPUTER-READABLE STORAGE MEDIUM**

(30) Priority: 10.01.2023 CN 202310032473
(71) Applicant: Huawei Technologies Co., Ltd., Shenzhen, Guangdong 518129 (CN)
(72) Inventor: HE, Xiang, Shenzhen, Guangdong 518129 (CN); REN, Hao, Shenzhen, Guangdong 518129 (CN)
(74) Representative: Huawei European IPR
(86) International application number: PCT/CN2023/136532
(87) International publication number: WO 2024/148983

(57) **Abstract**

This application relates to the field of communication technologies, and discloses an alignment marker search method and apparatus, a system, and a computer-readable storage medium. The method includes: A first module receives a first data stream, where the first data stream is obtained by multiplexing a plurality of second data streams at a reference granularity, any second data stream includes an AM and data from at least one FEC codeword, and the reference granularity is a quantity of bits corresponding to n symbols included in the FEC codeword; obtains a first data segment from a first location in the first data stream at the reference granularity, and performs AM search on the first data segment. In the method, the reference granularity is the quantity of bits corresponding to the n symbols. Therefore, when a burst bit error occurs in the first data stream, a quantity of symbols affected by the burst bit error is small. In comparison with a data stream obtained through bit multiplexing, the first data stream in this method has higher tolerance to the burst bit error.

## Description

This application claims priority to Chinese Patent Application No. 202310032473.9, filed on January 10, 2023 and entitled "ALIGNMENT MARKER SEARCH METHOD AND APPARATUS, SYSTEM, AND COMPUTER-READABLE STORAGE MEDIUM", which is incorporated herein by reference in its entirety.

### TECHNICAL FIELD

This application relates to the field of communication technologies, and in particular, to an alignment marker search method and apparatus, a system, and a computer-readable storage medium.

### BACKGROUND

With development of communication technologies, a rate of an Ethernet interface continuously increases. Because the rate of the Ethernet interface is much higher than a rate of a single lane connected to the Ethernet interface, multi-lane parallel transmission of data streams sent through the Ethernet interface becomes a manner of implementing adaptation between the rate of the lane and the rate of the Ethernet interface.

Skew (skew) easily occurs during transmission of the data streams through a plurality of lanes. Therefore, a transmitter of the data streams needs to insert alignment markers (alignment marker, AM) into the data streams transmitted through the plurality of lanes, so that a receiver of the data streams searches for the AMs, to align, based on the AMs, the data streams transmitted through the plurality of lanes, and then accurately obtain data.

### SUMMARY

This application provides an alignment marker search method and apparatus, a system, and a computer-readable storage medium, to perform AM search on a data stream.

According to a first aspect, an alignment marker search method is provided. The method includes: A first module receives a first data stream transmitted by a second module, where the first data stream is obtained by multiplexing a plurality of second data streams at a reference granularity, any second data stream includes an AM and data from at least one forward error correction (forward error correction, FEC) codeword, the reference granularity is a quantity of bits corresponding to n symbols included in the FEC codeword, and n is a positive integer. The first module then obtains a first data segment from a first location in the first data stream at the reference granularity, and performs AM search on the first data segment, where the first location is any location in the first data stream.

In the method, the first data stream is obtained by multiplexing the plurality of second data streams at the reference granularity of the quantity of bits corresponding to the n symbols included in the FEC codeword. Therefore, when a burst bit error occurs in the first data stream, a quantity of symbols affected by the burst bit error is small. If the first data stream is obtained by performing bit multiplexing on the plurality of second data streams, and the bit multiplexing is performed on the plurality of data streams at a granularity of 1 bit, a burst bit error affects a plurality of symbols, and consequently, a quantity of the symbols affected by the burst bit error is large. Therefore, in comparison with performing AM search in a data stream obtained through bit multiplexing, the method provided in this application has higher tolerance (tolerance) to the burst bit error.

In a possible implementation, obtaining the first data segment from the first location in the first data stream at the reference granularity includes: demultiplexing the first data stream from the first location in the first data stream at the reference granularity, to obtain the first data segment. Therefore, when the first location is a boundary for performing multiplexing, data included in the first data segment may come from a same second data stream, and subsequently, AM search may continue to be performed on the first data segment. For example, AM search may be performed on the first data segment in an AM search manner specified in the Institute of Electrical and Electronics Engineers (Institute of Electrical and Electronics Engineers, IEEE) 802.3 standard.

In a possible implementation, obtaining the first data segment from the first location in the first data stream at the reference granularity includes: obtaining a first quantity of bits at an interval of first quantity of bits from the first location in the first data stream, and obtaining the first data segment based on a plurality of groups of first quantity of bits that are obtained, where the first quantity is determined based on the reference granularity. In comparison with the manner of obtaining the first data segment through demultiplexing, in this implementation, the first data stream does not need to be demultiplexed, and the first data segment may be directly obtained by obtaining the bits from the first data stream at an interval of the first quantity, thereby improving efficiency of obtaining the first data segment. In addition, in the method, the first data segment may be obtained through demultiplexing, or the first data segment may be obtained by directly obtaining the bits from the first data stream. The manner of obtaining the first data segment is flexible.

In a possible implementation, the method further includes: obtaining a second data segment from a second location in the first data stream at the reference granularity based on no AM being found in the first data segment, and performing AM search on the second data segment, where the second location is different from the first location. In other words, if no AM is found in the first data segment, it means that the first location is not the boundary for performing multiplexing. In this case, the second data segment may be obtained from another location in the first data stream, namely, the second location, and AM search is performed in the second data segment.

In a possible implementation, the second location is a location after the first location by a second quantity of bits, or the second location is a location after the first location by a third quantity of reference symbols, where a type of the reference symbol is determined based on a modulation scheme corresponding to the second data stream, and the second quantity is different from a quantity of bits corresponding to the third quantity of reference symbols. The manner of determining the second location is flexible.

In a possible implementation, the AM includes a common marker (common marker, CM) field, and the CM field is used to perform AM search on the first data segment. When AM search is performed based on the CM field, if the CM field is found, it is considered that the AM is found, thereby improving efficiency of AM search.

In a possible implementation, the FEC codeword is a Reed-Solomon (Reed-Solomon, RS) codeword.

According to a second aspect, an alignment marker search method is provided. The method includes: A second module obtains a first data stream, where the first data stream is obtained by multiplexing a plurality of second data streams at a reference granularity, any second data stream includes an AM and data from at least one FEC codeword, the reference granularity is a quantity of bits corresponding to n symbols included in the FEC codeword, and n is a positive integer. The second module then transmits the first data stream to a first module, to cause the first module to obtain a first data segment from a first location in the first data stream at the reference granularity, and to perform AM search on the first data segment, where the first location is any location in the first data stream.

In the method, the quantity of bits corresponding to the n symbols included in the FEC codeword is used as the reference granularity, and the plurality of second data streams are multiplexed to obtain the first data stream. Therefore, when a burst bit error occurs in the first data stream, a quantity of symbols affected by the burst bit error is small. If a manner of performing bit multiplexing on the plurality of second data streams to obtain the first data stream is used, because bit multiplexing is performed on the plurality of data streams at a granularity of 1 bit, a burst bit error affects a plurality of symbols, and consequently, a quantity of the symbols affected by the burst bit error is large. Therefore, in comparison with a data stream obtained through bit multiplexing, the first data stream obtained according to the method has higher tolerance to the burst bit error.

According to a third aspect, an alignment marker search apparatus is provided. The apparatus is used in a first module, and the apparatus includes:
an obtaining unit, configured to receive a first data stream transmitted by a second module, where the first data stream is obtained by multiplexing a plurality of second data streams at a reference granularity, any second data stream includes an AM and data from at least one FEC codeword, the reference granularity is a quantity of bits corresponding to n symbols included in the FEC codeword, and n is a positive integer, where
the obtaining unit is further configured to obtain a first data segment from a first location in the first data stream at the reference granularity, where the first location is any location in the first data stream; and
a search unit, configured to perform AM search on the first data segment.

In a possible implementation, the obtaining unit is configured to demultiplex the first data stream from the first location in the first data stream at the reference granularity, to obtain the first data segment.

In a possible implementation, the obtaining unit is configured to obtain a first quantity of bits at an interval of first quantity of bits from the first location in the first data stream, and obtain the first data segment based on a plurality of groups of first quantity of bits that are obtained, where the first quantity is determined based on the reference granularity.

In a possible implementation, the search unit is further configured to: obtain a second data segment from a second location in the first data stream at the reference granularity based on no AM being found in the first data segment, where the second location is different from the first location; and perform AM search on the second data segment.

In a possible implementation, the second location is a location after the first location by a second quantity of bits, or the second location is a location after the first location by a third quantity of reference symbols, where a type of the reference symbol is determined based on a modulation scheme corresponding to the second data stream, and the second quantity is different from a quantity of bits corresponding to the third quantity of reference symbols.

In a possible implementation, the AM includes a CM field, and the CM field is used to perform AM search on the first data segment.

In a possible implementation, the FEC codeword is an RS codeword.

According to a fourth aspect, an alignment marker search apparatus is provided. The apparatus is used in a second module, and the apparatus includes:
an obtaining unit, configured to obtain a first data stream, where the first data stream is obtained by multiplexing a plurality of second data streams at a reference granularity, any second data stream includes an AM and data from at least one FEC codeword, the reference granularity is a quantity of bits corresponding to n symbols included in the FEC codeword, and n is a positive integer; and
a transmission unit, configured to: transmit the first data stream to a first module, to cause the first module to obtain a first data segment from a first location in the first data stream at the reference granularity, where the first location is any location in the first data stream, and to perform AM search on the first data segment.

According to a fifth aspect, a communication system is provided. The system includes a first module and a second module, where the first module is configured to perform the alignment marker search method according to any one of the first aspect, and the second module is configured to perform the alignment marker search method according to the second aspect.

According to a sixth aspect, a computer system is provided. The computer system includes a processor, and the processor includes a first module or a second module. If the processor includes the first module, when the processor executes program instructions or code, the computer system implements the alignment marker search method according to any one of the first aspect; or if the processor includes the second module, when the processor executes program instructions or code, the computer system implements the alignment marker search method according to the second aspect. For example, the computer system further includes a memory, and the memory is configured to store the program instructions or the code.

According to a seventh aspect, a computer-readable storage medium is provided. The computer-readable storage medium stores at least one program instruction or code, the program instruction or the code is executed by a computer, and the computer includes a first module or a second module. If the computer includes the first module, when the program instruction or the code is executed by the computer, the computer is caused to implement the alignment marker search method according to any one of the first aspect; or if the computer includes the second module, when the program instruction or the code is executed by the computer, the computer is caused to implement the alignment marker search method according to the second aspect.

According to an eighth aspect, a communication apparatus is provided. The apparatus includes a transceiver, a memory, and a processor. The transceiver, the memory, and the processor communicate with each other through an internal connection path. The memory is configured to store instructions. The processor is configured to execute the instructions stored in the memory, to control the transceiver to receive/send a signal. The processor includes a first module or a second module. If the processor includes the first module, when the processor executes the instructions stored in the memory, the processor is caused to perform the alignment marker search method according to any one of the first aspect. If the processor includes the second module, when the processor executes the instructions stored in the memory, the processor is caused to perform the alignment marker search method according to the second aspect.

For example, there are one or more processors, and there are one or more memories.

For example, the memory and the processor may be integrated together, or the memory and the processor are disposed separately.

In a specific implementation process, the memory may be a non-transitory (non-transitory) memory, for example, a read-only memory (read-only memory, ROM). The memory and the processor may be integrated on a same chip, or may be separately disposed on different chips. A type of the memory and a manner of disposing the memory and the processor are not limited in this application.

According to a ninth aspect, a computer program product is provided. The computer program product includes computer program instructions or code, the computer program instructions or the code is run by a computer, and the computer includes a first module or a second module. If the computer includes the first module, when the computer program instructions or the code is run by the computer, the computer is caused to perform the alignment marker search method according to any one of the first aspect; or if the computer includes the second module, when the computer program instructions or the code is run by the computer, the computer is caused to implement the alignment marker search method according to the second aspect.

According to a tenth aspect, a chip is provided. The chip includes a processor, the processor includes a first module or a second module, and the processor is configured to run program instructions or code. If the processor includes the first module, a device including the chip performs the alignment marker search method according to any one of the first aspect; or if the processor includes the second module, a device including the chip performs the alignment marker search method according to the second aspect.

For example, the chip further includes an input interface, an output interface, and a memory. The input interface, the output interface, the processor, and the memory are connected through an internal connection path, and the memory is configured to store the program instructions or the code.

It should be understood that, for beneficial effects achieved by the technical solutions of the third aspect to the tenth aspect of this application and the possible implementations corresponding to the third aspect to the tenth aspect, refer to the technical effects of the first aspect, the second aspect, and the possible implementations corresponding to the first aspect and the second aspect. Details are not described herein again.

### BRIEF DESCRIPTION OF DRAWINGS

FIG. 1 is a diagram of an implementation scenario of an alignment marker search method according to an embodiment of this application;
FIG. 2 is a flowchart of an alignment marker search method according to an embodiment of this application;
FIG. 3 is a diagram of multiplexing second data streams to obtain a first data stream according to an embodiment of this application;
FIG. 4 is a diagram of a first location according to an embodiment of this application;
FIG. 5 is a diagram of obtaining a plurality of groups of first quantity of bits according to an embodiment of this application;
FIG. 6 is a diagram of a structure of an alignment marker search apparatus according to an embodiment of this application;
FIG. 7 is a diagram of a structure of another alignment marker search apparatus according to an embodiment of this application;
FIG. 8 is a diagram of a structure of a computer system according to an embodiment of this application; and
FIG. 9 is a diagram of a structure of another computer system according to an embodiment of this application.

### DESCRIPTION OF EMBODIMENTS

Terms used in implementations of this application are merely used to explain embodiments of this application, but are not intended to limit this application. The following describes embodiments of this application with reference to the accompanying drawings.

With development of communication technologies, a rate of an Ethernet interface may increase faster than a rate of a single lane connected to the Ethernet interface. For example, a 10 gigabit Ethernet (gigabit Ethernet, GE) interface is connected to a single lane (lane) of 10 gigabits per second (gigabits per second, Gbps), a 100GE interface is connected to four 25 Gbps lanes, and a 400GE interface is connected to sixteen 25 Gbps lanes or eight 50 Gbps lanes. The lane may be a physical coding sublayer (physical coding sublayer, PCS) lane. It can be learned that, when the rate of the Ethernet interface increases from 10GE to 400GE, the rate of the single lane increases from 10 Gbps to 25 Gbp or 50 Gbps. In this case, transmission of data streams sent through the Ethernet interface may be performed in a multi-lane parallel transmission mode. When the Ethernet interface is connected to a plurality of lanes, the data streams may be transmitted in parallel through the plurality of lanes.

When the data streams are transmitted in parallel through the plurality of lanes, skew (skew) of the data streams on different lanes may be different. Therefore, a transmitter of the data streams inserts AMs into the data streams transmitted through the plurality of lanes, and a receiver of the data streams searches the data streams received from the plurality of lanes for the AMs, to obtain locations of the AMs inserted into the data streams transmitted through the lanes. Therefore, after obtaining the locations of the AMs, the receiver of the data streams aligns (including alignment lock (alignment lock) and deskew (deskew)), based on the locations of the AMs, the data streams transmitted through the plurality of lanes, and further decodes the data streams transmitted by the transmitter to the receiver through the plurality of lanes. Content of the AM is not changed during transmission. However, in the data streams, a specific bit sequence of the AM may be disordered due to a process like bit multiplexing or symbol multiplexing. The bit sequence may also be referred to as a bit pattern.

When the data streams are transmitted through a physical link, a rate of the physical link used to transmit the data streams may be higher than a rate of a PCS lane. For example, a rate of a single PCS lane is 25 Gbps, and the rate of the physical link used to transmit the data streams may be 50 Gbps or 100 Gbps. In this case, when the data streams on PCS lanes are transmitted through a physical link, the data streams transmitted through the plurality of PCS lanes need to be aggregated, and a data stream obtained through aggregation is transmitted through the physical link. The receiver of the data streams obtains, based on the data stream obtained through aggregation, the data streams transmitted through the PCS lanes, and may then perform AM search on the data streams transmitted through the PCS lanes.

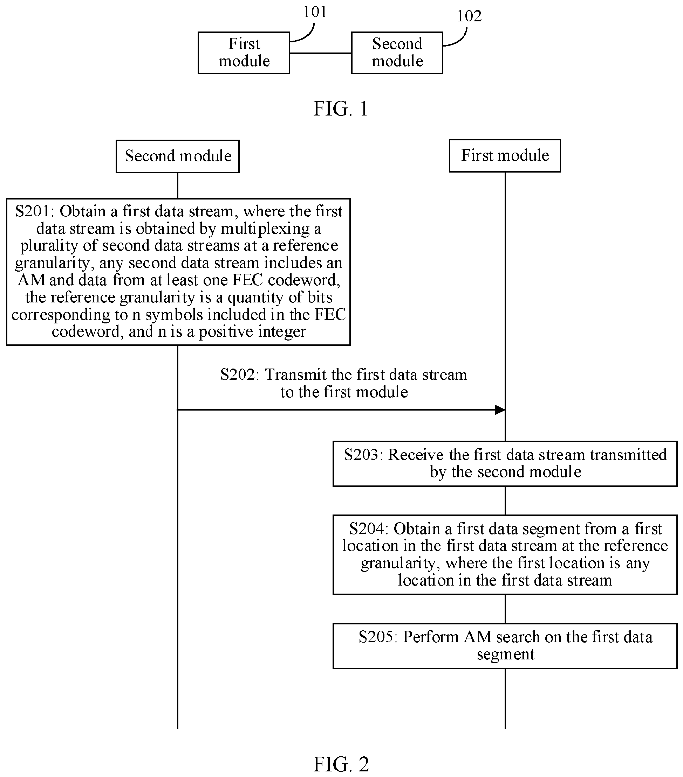

An embodiment of this application provides an alignment marker search method. The method is applicable to performing AM search on a data stream obtained through aggregation. FIG. 1 is a diagram of an implementation scenario of an alignment marker search method according to an embodiment of this application. Refer to FIG. 1. The implementation scenario includes a first module 101 and a second module 102, and the first module 101 and the second module 102 are communicatively connected. For example, the first module 101 and the second module 102 are communicatively connected through a plurality of physical links. For example, the first module 101 is included in a first device, and the second module 102 is included in a second device; or the first module 101 and the second module 102 may be included in a same device. A device in which any one or both of the first module 101 and the second module 102 are located may be a network device, or may be another device that includes an Ethernet interface or complies with the IEEE 802.3 standard. In addition, the implementation scenario shown in FIG. 1 may further include another module. This is not limited in embodiments of this application.

The alignment marker search method provided in this embodiment of this application may be shown in FIG. 2. The following describes, with reference to the implementation scenario shown in FIG. 1, the alignment marker search method provided in this embodiment of this application. As shown in FIG. 2, the method includes but is not limited to S201 and S202.

S201: The second module obtains a first data stream, where the first data stream is obtained by multiplexing a plurality of second data streams at a reference granularity, any second data stream includes an AM and data from at least one FEC codeword, the reference granularity is a quantity of bits corresponding to n symbols included in the FEC codeword, and n is a positive integer.

When multiplexing the plurality of second data streams to obtain the first data stream, the second module performs multiplexing at a reference granularity of a quantity of bits corresponding to one or more symbols of the FEC codeword, that is, n may be greater than or equal to 1. In some embodiments, n may be 2^{m}, and m is a positive integer greater than or equal to 1. For example, n is 2, 4, 8, or 16. The FEC codeword may be a Reed-Solomon (Reed-Solomon, RS) codeword. In this embodiment of this application, n may be determined based on a quantity of FEC codewords corresponding to the second data stream. For example, for any second data stream, the second data stream includes data from two FEC codewords. In other words, a quantity of FEC codewords corresponding to the second data stream is 2. In this case, n is greater than or equal to 2.

For example, for any second data stream in the plurality of second data streams, an AM included in the second data stream corresponds to a lane transmitting the second data stream. For example, the second data streams are data streams transmitted through PCS lanes, and the AMs included in the second data streams are in one-to-one correspondence with sequence numbers of the PCS lanes transmitting the second data streams. When eight PCS lanes are used to transmit the plurality of second data streams in parallel, the correspondence between the AMs included in the second data streams and the sequence numbers of the PCS lanes transmitting the second data streams may be shown in Table 1.

**Table 1**

| Sequence number | 0 | 1 | 2 | 3 | 4 | 5 | 6 | 7 |
|---|---|---|---|---|---|---|---|---|
| CM 0 | 0x9A | 0x9A | 0x9A | 0x9A | 0x9A | 0x9A | 0x9A | 0x9A |
| CM 1 | 0x4A | 0x4A | 0x4A | 0x4A | 0x4A | 0x4A | 0x4A | 0x4A |
| CM 2 | 0x26 | 0x26 | 0x26 | 0x26 | 0x26 | 0x26 | 0x26 | 0x26 |
| UP 0 | 0x05 | 0x04 | 0x46 | 0x5A | 0xE1 | 0xF2 | 0x3D | 0x22 |
| CM 3 | 0x65 | 0x65 | 0x65 | 0x65 | 0x65 | 0x65 | 0x65 | 0x65 |
| CM 4 | 0xB5 | 0xB5 | 0xB5 | 0xB5 | 0xB5 | 0xB5 | 0xB5 | 0xB5 |
| CM 5 | 0xD9 | 0xD9 | 0xD9 | 0xD9 | 0xD9 | 0xD9 | 0xD9 | 0xD9 |
| UP 1 | 0xD6 | 0x67 | 0xFE | 0x84 | 0x19 | 0x4E | 0xEE | 0x32 |
| UM 0 | 0xB3 | 0x5A | 0x3E | 0x86 | 0x2A | 0x12 | 0x42 | 0xD6 |
| UM1 | 0xC0 | 0xDE | 0xF3 | 0x80 | 0x51 | 0x4F | 0x9C | 0x76 |
| UM 2 | 0x8C | 0x7E | 0x56 | 0xD0 | 0xF2 | 0xD1 | 0xA1 | 0x5B |
| UP 2 | 0x29 | 0x98 | 0x01 | 0x7B | 0xE6 | 0xB1 | 0x11 | 0xCD |
| UM 3 | 0x4C | 0xA5 | 0xC1 | 0x79 | 0xD5 | 0xED | 0xBD | 0x29 |
| UM 4 | 0x3F | 0x21 | 0x0C | 0x7F | 0xAE | 0xB0 | 0x63 | 0x89 |
| UM 5 | 0x73 | 0x81 | 0xA9 | 0x2F | 0x0D | 0x2E | 0x5E | 0xA4 |

As shown in Table 1, the eight PCS lanes are respectively PCS lane 0 to PCS lane 7 whose sequence numbers are 0 to 7, and the AM corresponding to any PCS lane includes CM fields, unique marker (unique marker, UM) fields, and unique pad (unique pad, UP) fields. CMs 0 to CMs 5 in AMs corresponding to all the PCS lanes have same values respectively. For example, in Table 1, the value of CM 0 in each AM is 0x9A, the value of CM 1 in each AM is 0x4A, the value of CM 2 in each AM is 0x26, the value of CM 3 in each AM is 0x65, the value of CM 4 in each AM is 0xB5, and the value of CM 5 in each AM is 0xD9. Values of UM 0 to UM 5 in an AM corresponding to each PCS lane uniquely correspond to the PCS lane, and values of UP 0 to UP 2 may also uniquely correspond to each PCS lane. For example, values of UMs 0 in the AMs in PCS lanes 0 to 7 are respectively 0xB3, 0x5A, 0x3E, 0x86, 0x2A, 0x12, 0x42, and 0xD6, and values of UPs 0 in the AMs in PCS lanes 0 to 7 are respectively 0x05, 0x04, 0x46, 0x5A, 0xE1, 0xF2, 0x3D, and 0x22. For example, the values of UP 0 to UP 2 are padding data unrelated to an AM lock mechanism. Content in Table 1 is intended to describe the correspondence between the PCS lanes and theAMs and content included in the AM, and is not used to limit a numbering manner of the PCS lanes.

When 16 PCS lanes are used to transmit the plurality of second data streams in parallel, the correspondence between the AMs included in the second data streams and the sequence numbers of the PCS lanes transmitting the second data streams may be shown in Table 2 and Table 3.

**Table 2**

| Sequence number | 0 | 1 | 2 | 3 | 4 | 5 | 6 | 7 |
|---|---|---|---|---|---|---|---|---|
| CM 0 | 0x9A | 0x9A | 0x9A | 0x9A | 0x9A | 0x9A | 0x9A | 0x9A |
| CM 1 | 0x4A | 0x4A | 0x4A | 0x4A | 0x4A | 0x4A | 0x4A | 0x4A |
| CM 2 | 0x26 | 0x26 | 0x26 | 0x26 | 0x26 | 0x26 | 0x26 | 0x26 |
| UP 0 | 0xB6 | 0x04 | 0x46 | 0x5A | 0xE1 | 0xF2 | 0x3D | 0x22 |
| CM 3 | 0x65 | 0x65 | 0x65 | 0x65 | 0x65 | 0x65 | 0x65 | 0x65 |
| CM 4 | 0xB5 | 0xB5 | 0xB5 | 0xB5 | 0xB5 | 0xB5 | 0xB5 | 0xB5 |
| CM 5 | 0xD9 | 0xD9 | 0xD9 | 0xD9 | 0xD9 | 0xD9 | 0xD9 | 0xD9 |
| UP 1 | 0xD9 | 0x67 | 0xFE | 0x84 | 0x19 | 0x4E | 0xEE | 0x32 |
| UM 0 | 0x01 | 0x5A | 0x3E | 0x86 | 0x2A | 0x12 | 0x42 | 0xD6 |
| UM1 | 0x71 | 0xDE | 0xF3 | 0x80 | 0x51 | 0x4F | 0x9C | 0x76 |
| UM2 | 0xF3 | 0x7E | 0x56 | 0xD0 | 0xF2 | 0xD1 | 0xA1 | 0x5B |
| UP 2 | 0x26 | 0x98 | 0x01 | 0x7B | 0xE6 | 0xB1 | 0x11 | 0xCD |
| UM 3 | 0xFE | 0xA5 | 0xC1 | 0x79 | 0xD5 | 0xED | 0xBD | 0x29 |
| UM 4 | 0x8E | 0x21 | 0x0C | 0x7F | 0xAE | 0xB0 | 0x63 | 0x89 |
| UM 5 | 0x0C | 0x81 | 0xA9 | 0x2F | 0x0D | 0x2E | 0x5E | 0xA4 |

**Table 3**

| Sequence number | 8 | 9 | 10 | 11 | 12 | 13 | 14 | 15 |
|---|---|---|---|---|---|---|---|---|
| CM 0 | 0x9A | 0x9A | 0x9A | 0x9A | 0x9A | 0x9A | 0x9A | 0x9A |
| CM 1 | 0x4A | 0x4A | 0x4A | 0x4A | 0x4A | 0x4A | 0x4A | 0x4A |
| CM 2 | 0x26 | 0x26 | 0x26 | 0x26 | 0x26 | 0x26 | 0x26 | 0x26 |
| UP 0 | 0x60 | 0x6B | 0xFA | 0x6C | 0x18 | 0x14 | 0xD0 | 0xB4 |
| CM 3 | 0x65 | 0x65 | 0x65 | 0x65 | 0x65 | 0x65 | 0x65 | 0x65 |
| CM 4 | 0xB5 | 0xB5 | 0xB5 | 0xB5 | 0xB5 | 0xB5 | 0xB5 | 0xB5 |
| CM 5 | 0xD9 | 0xD9 | 0xD9 | 0xD9 | 0xD9 | 0xD9 | 0xD9 | 0xD9 |
| UP 1 | 0x9F | 0xA2 | 0x04 | 0x71 | 0x5B | 0xCC | 0xB1 | 0x56 |
| UM 0 | 0xE1 | 0x71 | 0x95 | 0x22 | 0xA2 | 0x31 | 0xCA | 0xA6 |
| UM1 | 0x73 | 0xC4 | 0xEB | 0x66 | 0xF6 | 0x97 | 0xFB | 0xBA |
| UM 2 | 0x75 | 0x3C | 0xD8 | 0x38 | 0x95 | 0xC3 | 0xA6 | 0x79 |
| UP 2 | 0x60 | 0x5D | 0xFB | 0x8E | 0xA4 | 0x33 | 0x4E | 0xA9 |
| UM 3 | 0x1E | 0x8E | 0x6A | 0xDD | 0x5D | 0xCE | 0x35 | 0x59 |
| UM 4 | 0x8C | 0x3B | 0x14 | 0x99 | 0x09 | 0x68 | 0x04 | 0x45 |
| UM 5 | 0x8A | 0xC3 | 0x27 | 0xC7 | 0x6A | 0x3C | 0x59 | 0x86 |

As shown in Table 2 and Table 3, the 16 PCS lanes are respectively PCS lane 0 to PCS lane 15 whose sequence numbers are 0 to 15. A principle of the correspondence between the PCS lanes and the AMs is the same as that shown in Table 1. Details are not described herein again. In addition, content in Table 2 and Table 3 is intended to describe the correspondence between the PCS lanes and the AMs and content included in the AM, and is not used to limit a numbering manner of the PCS lanes.

With reference to the content in Table 1 to Table 3, CM 0 to CM 5, UM 0 to UM 5, and UP 0 and UP 2 may each include eight bits, so that one AM may include 120 bits (bit). The 120 bits may come from a plurality of FEC codewords. For example, when a symbol of the FEC codeword includes 10 bits, a 120-bit AM may be allocated to a plurality of FEC codewords in a unit of 10 bits. Certainly, the AM may further include bits other than the 120 bits. For example, the AM may further include padding (pad or padding), and the pad or the padding is used to adjust a quantity of bits included in the AM to a specified quantity. The quantity of bits included in the AM is not limited in embodiments of this application.

It should be noted that the eight groups of AMs shown in Table 1 are specific to a 200GE interface. If there is an interface of another rate, different AMs may be used. For ease of design, for a plurality of PCS lanes connected to any interface, respective CM fields in AMs corresponding to the PCS lanes may be the same, for example, as shown in Table 1 to Table 3, but UMs are different. In addition, Table 2 and Table 3 are specific to a 400GE interface. If 16 lanes are used for an interface of another rate, AMs may be different. Table 1 to Table 3 above are merely examples for description, and do not limit various cases of the correspondence between the AMs and the PCS lanes to which this application is applicable. In addition, Table 1 is used as an example to describe the AMs corresponding to the PCS lanes connected to the 200GE interface. Table 2 and Table 3 are used as examples to describe the AMs corresponding to the PCS lanes connected to the 400GE interface. For an interface of another rate, AMs may be different from the content in Table 1 to Table 3. For example, the AM does not include UP fields.

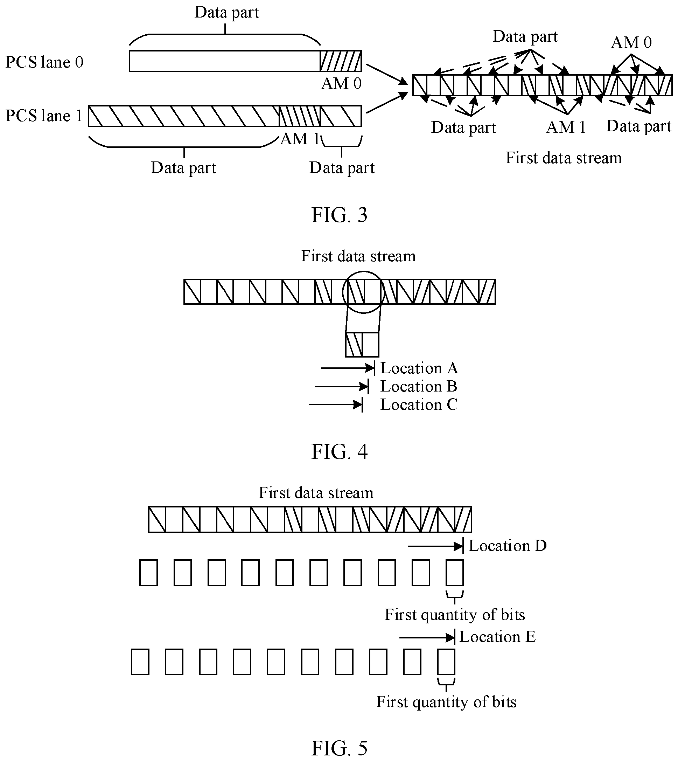

FIG. 3 is a diagram of multiplexing second data streams to obtain a first data stream according to an embodiment of this application. As shown in FIG. 3, two second data streams are transmitted respectively through PCS lane 0 and PCS lane 1. The two second data streams each include an AM and a data part from an FEC codeword. An AM used when a second data stream is transmitted through PCS lane 0 is AM 0, and an AM used when a second data stream is transmitted through PCS lane 1 is AM 1. For example, a symbol of the FEC codeword includes 10 bits, and n is equal to 4, that is, a reference granularity is 40 bits. AM 0 and AM 1 each are divided into three parts for multiplexing, and the data part that is from the FEC codeword and that is in the second data stream is also multiplexed at the reference granularity, to obtain the first data stream.

For example, in this embodiment of this application, when the plurality of second data streams are multiplexed, deskew (deskew) is first performed on the plurality of second data streams, and then the plurality of second data streams obtained through deskew are multiplexed. When deskew is performed on the plurality of second data streams, there is no need to perform full deskew (full deskew) on the plurality of second data streams. To be specific, there is no need to fully align the plurality of second data streams based on the AMs in the plurality of second data streams, provided that deskew is performed on the plurality of second data streams to the reference granularity for multiplexing, that is, an AM of one second data stream may be aligned with a data part of the other second data stream, provided that the plurality of second data streams can be multiplexed at the reference granularity. As shown in FIG. 3, AM 1 is aligned with the data part in the second data stream transmitted through PCS lane 0, and is not aligned with AM 0.

S202: The second module transmits the first data stream to the first module.

A manner in which the second module transmits the first data stream to the first module is not limited in embodiments of this application. For example, the second module transmits the first data stream to the first module through a physical link. The first module may obtain a first data segment from a first location in the first data stream at the reference granularity, and perform AM search on the first data segment, where the first location is any location in the first data stream. For a process in which the first module obtains the first data segment and performs AM search on the first data segment, refer to S203 to S205. Details are not described herein.

In the method provided in this embodiment of this application, the quantity of bits corresponding to the n symbols included in the FEC codeword is used as the reference granularity, and the plurality of second data streams are multiplexed to obtain the first data stream. Therefore, when a burst bit error occurs in the first data stream, a quantity of symbols affected by the burst bit error is small. If a manner of performing bit multiplexing on the plurality of second data streams to obtain the first data stream is used, because bit multiplexing is performed on the plurality of data streams at a granularity of 1 bit, a burst bit error affects a plurality of symbols, and consequently, a quantity of the symbols affected by the burst bit error is large. Therefore, in comparison with a data stream obtained through bit multiplexing, the first data stream obtained according to the method has higher tolerance to the burst bit error.

The foregoing uses a second module side as an example to describe the alignment marker search method provided in this embodiment of this application. The following uses a first module side as an example to describe the method. As shown in FIG. 2, the method includes but is not limited to S203 to S205.

S203: The first module receives the first data stream transmitted by the second module.

A manner in which the first module receives the first data stream transmitted by the second module is not limited in embodiments of this application, provided that the manner corresponds to a manner in which the second module transmits the first data stream to the first module. The first data stream is obtained by multiplexing the plurality of second data streams at the reference granularity, any second data stream includes an AM and a data from at least one FEC codeword, the reference granularity is a quantity of bits corresponding to n symbols included in the FEC codeword, and n is a positive integer.

S204: The first module obtains the first data segment from the first location in the first data stream at the reference granularity, where the first location is any location in the first data stream.

In a possible implementation, the first module performs, in Manner 1 or Manner 2 below, the operation of obtaining the first data segment from the first location in the first data stream at the reference granularity.

Manner 1: Demultiplex the first data stream from the first location in the first data stream at the reference granularity, to obtain the first data segment.

In Manner 1, the first module may demultiplex, starting from any location in the first data stream, the first data stream at a granularity same as the reference granularity for multiplexing. Therefore, when the first location is a boundary for performing multiplexing, data included in the first data segment may come from a same second data stream.

FIG. 4 is a diagram of the first location according to an embodiment of this application. Refer to FIG. 4. If the first location is location A or location B in the first data stream, because location A and location B are not boundaries for performing multiplexing, the obtained first data segment includes not only data of the second data stream transmitted through PCS lane 0, but also data of the second data stream transmitted through PCS lane 1. In other words, the data included in the first data segment comes from two second data streams. If the first location is location C in the first data stream, because location C is a boundary for performing multiplexing, the obtained first data segment includes only data of the second data stream transmitted through PCS lane 0, or includes only data of the second data stream transmitted through PCS lane 1. In other words, the data included in the first data segment comes from the same second data stream. In this embodiment of this application, when the first data segment is obtained by demultiplexing the first data stream, AM search may continue to be subsequently performed on the first data segment. For example, AM search may be performed on the first data segment in an AM search manner specified in the IEEE802.3 standard.

Manner 2: Obtain a first quantity of bits at an interval of first quantity of bits from the first location in the first data stream, and obtain the first data segment based on a plurality of groups of first quantity of bits that are obtained, where the first quantity is determined based on the reference granularity.

In comparison with the manner of obtaining the first data segment through demultiplexing in Manner 1, in Manner 2, the first data stream is not demultiplexed, and the first data segment is directly obtained by obtaining the bits from the first data stream at an interval of the first quantity, so that efficiency of obtaining the first data segment is high. In this embodiment of this application, the first quantity is equal to the quantity of bits corresponding to the reference granularity. For example, when a symbol of the FEC codeword includes 10 bits, n*10 consecutive bits are obtained at an interval of n*10 consecutive bits in the first data stream, and then the first data segment is obtained based on a plurality of groups of n*10 bits that are obtained.

FIG. 5 is a diagram of obtaining a plurality of groups of first quantity of bits. Refer to FIG. 5. If the first module uses location D as the first location, the first module obtains, starting from location D, the first quantity of bits at an interval of first quantity of bits in the first data stream. If the first module uses location E as the first location, the first module obtains, starting from location E, the first quantity of bits at an interval of first quantity of bits in the first data stream. Location E is a location after location D by one bit.

S205: The first module performs AM search on the first data segment.

For example, CM fields included in the AM are used to perform AM search on the first data segment, so that an amount of data needed for performing AM search is small, and efficiency of AM search is high. The CM fields may include CM 0 to CM 5 in Table 1 to Table 3. In this embodiment of this application, for any second data stream, an AM corresponding to a PCS lane transmitting the second data stream may be inserted into the second data stream at an interval. When AM search is performed based on the CM fields, if the CM fields are found, it is considered that the AM is found. In this embodiment of this application, for any second data stream, an AM corresponding to a PCS lane transmitting the second data stream may be repeatedly inserted into the second data stream at a reference interval. In this case, if the CM fields are found p consecutive times in the first data segment at the reference interval for inserting the AM, it is considered that the AM is found p consecutive times in the first data segment at the reference interval of the AM, and AM lock (lock) succeeds, where p may be a positive integer greater than or equal to 2. A manner of searching for the CM fields is not limited in embodiments of this application. For example, each CM field includes two nibbles (nibble), and CM 0 to CM 5 include 12 nibbles in total. If nine nibbles of the 12 nibbles can be found in the first data segment, it is determined that the CM fields are found.

In a possible implementation, the first module may alternatively perform AM search on the first data segment based on a plurality of fields in the AM. For example, the first module performs AM search on the first data segment based on the CM fields and UM fields in the AM. In other words, in addition to searching for the CM fields, the first module may further search for the UM fields. Therefore, if both the CM fields and the UM fields are found in the first data segment, it is considered that the AM is found in the first data segment. A manner of searching for the UM fields is not limited in embodiments of this application. For example, each UM field includes two nibbles, and UM 0 to UM 5 include 12 nibbles in total. If nine nibbles of the 12 nibbles can be found in the first data segment, it is determined that the UM fields are found.

In a possible implementation, the method further includes: obtaining a second data segment from a second location in the first data stream at the reference granularity based on no AM being found in the first data segment, where the second location is different from the first location; and performing AM search on the second data segment. In other words, if no AM is found in the first data segment, it means that the first location is not the boundary for performing multiplexing. In this case, the second data segment may be obtained from another location in the first data stream, namely, the second location, and AM search is performed in the second data segment. A principle of content of performing AM search in the second data segment is the same as that in S205. Details are not described herein again. For example, if no AM is found after bits of a reference length, it is determined that no AM is found in the first data segment. The reference length may be determined based on experience or an actual requirement. For example, the reference length is five times the insertion interval of the AM.

The second location may be a location after the first location by a second quantity of bits, or the second location may be a location after the first location by a third quantity of reference symbols, where a type of the reference symbol is determined based on a modulation scheme corresponding to the second data stream, and the second quantity is different from a quantity of bits corresponding to the third quantity of reference symbols. The modulation scheme corresponding to the second data stream may be 4-level pulse amplitude modulation (4-level pulse amplitude modulation, PAM4), so that the reference symbol may be a PAM4 symbol. Alternatively, the modulation scheme corresponding to the second data stream is 3-level pulse amplitude modulation (3-level pulse amplitude modulation, PAM3), so that the reference symbol may be a PAM3 symbol. Alternatively, the modulation scheme corresponding to the second data stream is 5-level pulse amplitude modulation (5-level pulse amplitude modulation, PAM5), so that the reference symbol may be a PAM5 symbol. Alternatively, the modulation scheme corresponding to the second data stream may be 6-level pulse amplitude modulation (6-level pulse amplitude modulation, PAM6), so that the reference symbol may be a PAM6 symbol. Alternatively, the modulation scheme corresponding to the second data stream is 8-level pulse amplitude modulation (8-level pulse amplitude modulation, PAM8), so that the reference symbol may be a PAM8 symbol. Alternatively, the modulation scheme corresponding to the second data stream is 16-level pulse amplitude modulation (16-level pulse amplitude modulation, PAM16), so that the reference symbol may be a PAM16 symbol. Alternatively, an adjustment manner corresponding to the second data stream is quadrature amplitude modulation (quadrature amplitude modulation, QAM), so that the reference symbol may be a QAM symbol.

For example, if no AM is found in the second data segment, the first module may continue to change a location, obtain a data segment from a changed location in the first data stream, and perform AM search on the obtained data segment. The first module cyclically performs a process of changing a location, obtaining a data segment, and performing AM search on the data segment until the AM is found in the data segment.

Because the granularity for multiplexing is fixed, the boundary for multiplexing appears periodically. Therefore, when the location is changed, the location may be a location after location A by one bit, or by x*n*10 bit+1 bit. x is a positive integer greater than or equal to 1. For example, as shown in FIG. 4, when location A is the first location, and the first module finds no AM in the first data segment, the first module may use location B after location A by one bit as the second location to obtain the second data segment, and perform AM search on the obtained second data segment. If the first module finds no AM in the second data segment, the first module may use location C after location B by one bit as a third location, obtain a third data segment from location C in the first data stream at the reference granularity, and perform AM search on the third data segment. For another example, as shown in FIG. 5, when location D is the first location, and the first module finds no AM in the first data segment, the first module may use location E after location D by one bit as the second location to obtain the second data segment, and perform AM search on the obtained second data segment.

In addition, when the first data segment is obtained through demultiplexing, if a plurality of first data segments are obtained, AM search may be performed on each first data segment. If AM lock on any first data segment in the plurality of first data segments fails, it is determined that the first location is not the boundary for performing multiplexing, and the first module performs the operation of obtaining the second data segment from the second location in the first data stream at the reference granularity and performing AM search on the second data segment.

The method provided in this embodiment of this application is applicable to performing AM search on the first data stream. In the method, the first data stream is obtained by multiplexing the plurality of second data streams at the reference granularity of the quantity of bits corresponding to the n symbols included in the FEC codeword. Therefore, when a burst bit error occurs in the first data stream, a quantity of symbols affected by the burst bit error is small. If the first data stream is obtained by performing bit multiplexing on the plurality of second data streams, and the bit multiplexing is performed on the plurality of data streams at a granularity of 1 bit, a burst bit error affects a plurality of symbols, and consequently, a quantity of the symbols affected by the burst bit error is large. Therefore, in comparison with performing AM search in a data stream obtained through bit multiplexing, the method provided in this embodiment of this application has higher tolerance to the burst bit error.

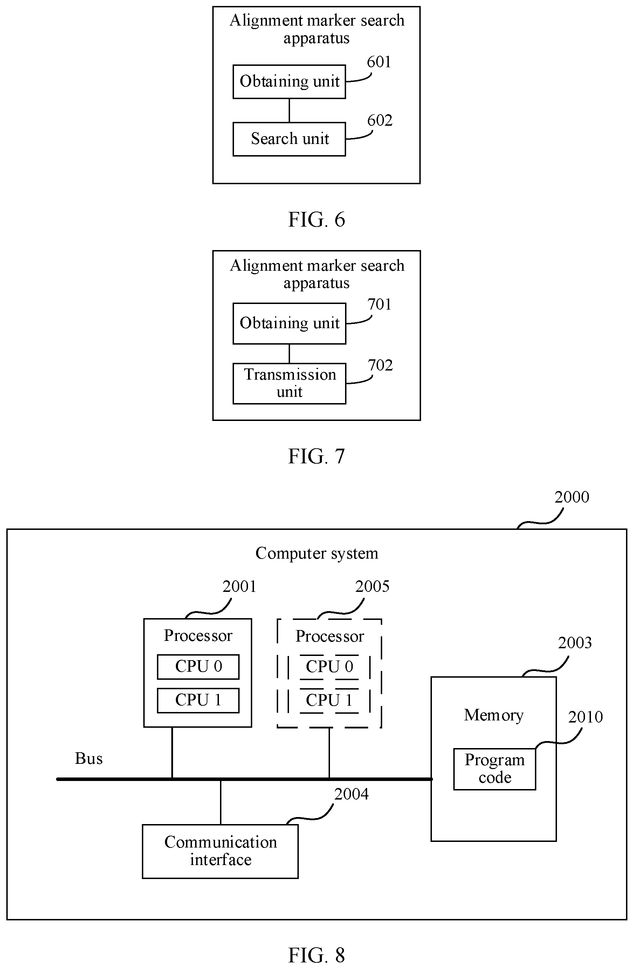

An embodiment of this application further provides an alignment marker search apparatus. FIG. 6 is a diagram of a structure of an alignment marker search apparatus according to an embodiment of this application. Based on a plurality of units shown in FIG. 6, the alignment marker search apparatus shown in FIG. 6 can perform all or some of the operations performed by the first module. It should be understood that the apparatus may include more additional units than the units shown, or may omit some of the units shown. This is not limited in embodiments of this application. As shown in FIG. 6, the apparatus includes:
an obtaining unit 601, configured to receive a first data stream transmitted by a second module, where the first data stream is obtained by multiplexing a plurality of second data streams at a reference granularity, any second data stream includes an AM and data from at least one FEC codeword, the reference granularity is a quantity of bits corresponding to n symbols included in the FEC codeword, and n is a positive integer, where
the obtaining unit 601 is further configured to obtain a first data segment from a first location in the first data stream at the reference granularity, where the first location is any location in the first data stream; and
a search unit 602, configured to perform AM search on the first data segment.

In a possible implementation, the obtaining unit 601 is configured to demultiplex the first data stream from the first location in the first data stream at the reference granularity, to obtain the first data segment.

In a possible implementation, the obtaining unit 601 is configured to obtain a first quantity of bits at an interval of first quantity of bits from the first location in the first data stream, and obtain the first data segment based on a plurality of groups of first quantity of bits that are obtained, where the first quantity is determined based on the reference granularity.

In a possible implementation, the search unit 602 is further configured to: obtain a second data segment from a second location in the first data stream at the reference granularity based on no AM being found in the first data segment, where the second location is different from the first location; and perform AM search on the second data segment.

In a possible implementation, the second location is a location after the first location by a second quantity of bits, or the second location is a location after the first location by a third quantity of reference symbols, where a type of the reference symbol is determined based on a modulation scheme corresponding to the second data stream, and the second quantity is different from a quantity of bits corresponding to the third quantity of reference symbols.

In a possible implementation, the AM includes a CM field, and the CM field is used to perform AM search on the first data segment.

In a possible implementation, the FEC codeword is an RS codeword.

The apparatus provided in this embodiment of this application is applicable to performing AM search on the first data stream. In the apparatus, the first data stream is obtained by multiplexing the plurality of second data streams at the reference granularity of the quantity of bits corresponding to the n symbols included in the FEC codeword. Therefore, when a burst bit error occurs in the first data stream, a quantity of symbols affected by the burst bit error is small. If the first data stream is obtained by performing bit multiplexing on the plurality of second data streams, and the bit multiplexing is performed on the plurality of data streams at a granularity of 1 bit, a burst bit error affects a plurality of symbols, and consequently, a quantity of the symbols affected by the burst bit error is large. Therefore, in comparison with performing AM search in a data stream obtained through bit multiplexing, the apparatus has higher tolerance to the burst bit error.

FIG. 7 is a diagram of a structure of another alignment marker search apparatus according to an embodiment of this application. Based on a plurality of units shown in FIG. 7, the alignment marker search apparatus shown in FIG. 7 can perform all or some of the operations performed by the second module. It should be understood that the apparatus may include more additional units than the units shown, or may omit some of the units shown. This is not limited in embodiments of this application. As shown in FIG. 7, the apparatus includes:
an obtaining unit 701, configured to obtain a first data stream, where the first data stream is obtained by multiplexing a plurality of second data streams at a reference granularity, any second data stream includes an AM and data from at least one FEC codeword, the reference granularity is a quantity of bits corresponding to n symbols included in the FEC codeword, and n is a positive integer; and
a transmission unit 702, configured to: transmit the first data stream to a first module, to cause the first module to obtain a first data segment from a first location in the first data stream at the reference granularity, where the first location is any location in the first data stream, and to perform AM search on the first data segment.

In the apparatus provided in this embodiment of this application, the quantity of bits corresponding to the n symbols included in the FEC codeword is used as the reference granularity, and the plurality of second data streams are multiplexed to obtain the first data stream. Therefore, when a burst bit error occurs in the first data stream, a quantity of symbols affected by the burst bit error is small. If a manner of performing bit multiplexing on the plurality of second data streams to obtain the first data stream is used, because bit multiplexing is performed on the plurality of data streams at a granularity of 1 bit, a burst bit error affects a plurality of symbols, and consequently, a quantity of the symbols affected by the burst bit error is large. Therefore, in comparison with a data stream obtained through bit multiplexing, the first data stream obtained by the apparatus has strong resistance to the burst bit error.

It should be understood that, when the apparatuses provided in FIG. 6 and FIG. 7 implements functions of the apparatuses, division of the foregoing functional units is merely used as an example for description. During actual application, the foregoing functions may be allocated to different functional units for implementation based on needs. That is, an internal structure of a device is divided into different functional units to implement all or some of the functions described above. In addition, the apparatuses provided in the foregoing embodiments belong to a same concept as the method embodiments. For specific implementation processes thereof, refer to the method embodiments. Details are not described herein again.

FIG. 8 is a diagram of a structure of a computer system according to an embodiment of this application. For example, as shown in FIG. 8, the computer system is a computer system 2000. The computer system 2000 may be a network device, and the network device may be a routing device or a switching device. The computer system 2000 shown in FIG. 8 is configured to perform the operations related to the first module or the second module in the alignment marker search method shown in FIG. 2. The computer system 2000 is, for example, a server, and the computer system 2000 may be implemented by using a general bus architecture.

As shown in FIG. 8, the computer system 2000 includes at least one processor 2001, a memory 2003, and at least one communication interface 2004.

The processor 2001 is, for example, a central processing unit (central processing unit, CPU), a digital signal processor (digital signal processor, DSP), a network processor (network processor, NP), a graphics processing unit (graphics processing unit, GPU), a neural-network processing unit (neural-network processing unit, NPU), a data processing unit (data processing unit, DPU), a microprocessor, or one or more integrated circuits configured to implement the solutions of this application. For example, the processor 2001 includes an application-specific integrated circuit (application-specific integrated circuit, ASIC), a programmable logic device (programmable logic device, PLD) or another programmable logic device, a transistor logic device, a hardware component, or any combination thereof. The PLD is, for example, a complex programmable logic device (complex programmable logic device, CPLD), a field programmable logic gate array (field programmable gate array, FPGA), a generic array logic (generic array logic, GAL), or any combination thereof. The processor can implement or execute various logical blocks, modules, and circuits described with reference to the content disclosed in embodiments of this application. Alternatively, the processor may be a combination of processors implementing a computing function, for example, a combination of one or more microprocessors, or a combination of a DSP and a microprocessor.

Optionally, the computer system 2000 further includes a bus. The bus is configured to perform transmission of information between the components of the computer system 2000. The bus may be a peripheral component interconnect (peripheral component interconnect, PCI for short) bus, an extended industry standard architecture (extended industry standard architecture, EISA for short) bus, or the like. Buses may be classified into an address bus, a data bus, a control bus, and the like. For ease of representation, only one thick line is used to represent the bus in FIG. 8, but this does not mean that there is only one bus or only one type of bus.

The memory 2003 is, for example, a read-only memory (read-only memory, ROM) or another type of static storage device that can store static information and instructions, a random access memory (random access memory, RAM) or another type of dynamic storage device that can store information and instructions, an electrically erasable programmable read-only memory (electrically erasable programmable read-only memory, EEPROM), a compact disc read-only memory (compact disc read-only memory, CD-ROM) or another optical disk storage, an optical disc storage (including a compact disc, a laser disc, an optical disc, a digital versatile disc, a Blu-ray disc, or the like), a disk storage medium or another magnetic storage device, or any other medium that can be used to carry or store expected program code in a form of instructions or a data structure and that can be accessed by a computer, but is not limited thereto. For example, the memory 2003 exists independently, and is connected to the processor 2001 through the bus. Alternatively, the memory 2003 and the processor 2001 may be integrated together.

The communication interface 2004 is any apparatus such as a transceiver, and is configured to communicate with another device or a communication network. The communication network may be an Ethernet, a radio access network (radio access network, RAN), a wireless local area network (wireless local area network, WLAN), or the like. The communication interface 2004 may include a wired communication interface, and may further include a wireless communication interface. Specifically, the communication interface 2004 may be an Ethernet (Ethernet) interface, a fast Ethernet (fast Ethernet, FE) interface, a gigabit Ethernet (gigabit Ethernet, GE) interface, an asynchronous transfer mode (asynchronous transfer mode, ATM) interface, a WLAN interface, a cellular network communication interface, or a combination thereof. The Ethernet interface may be an optical interface, an electrical interface, or a combination thereof. In this embodiment of this application, the communication interface 2004 may be used by the computer system 2000 to communicate with another device.

During specific implementation, in an embodiment, the processor 2001 may include one or more CPUs, for example, a CPU 0 and a CPU 1 shown in FIG. 8. Each of the processors may be a single-core (single-CPU) processor, or may be a multi-core (multi-CPU) processor. The processor herein may be one or more devices, circuits, and/or processing cores configured to process data (for example, computer program instructions).

During specific implementation, in an embodiment, the computer system 2000 may include a plurality of processors, such as the processor 2001 and a processor 2005 shown in FIG. 8. Each of the processors may be a single-core processor (single-CPU), or may be a multi-core processor (multi-CPU). The processor herein may be one or more devices, circuits, and/or processing cores configured to process data (for example, computer program instructions).

During specific implementation, in an embodiment, the computer system 2000 may further include an output device and an input device. The output device communicates with the processor 2001, and may display information in a plurality of manners. For example, the output device may be a liquid crystal display (liquid crystal display, LCD), a light emitting diode (light emitting diode, LED) display device, a cathode ray tube (cathode ray tube, CRT) display device, or a projector (projector). The input device communicates with the processor 2001, and may receive an input of a user in a plurality of manners. For example, the input device may be a mouse, a keyboard, a touchscreen device, or a sensing device.

In some embodiments, the memory 2003 is configured to store program code 2010 for executing the solutions of this application, and the processor 2001 may execute the program code 2010 stored in the memory 2003. The program code 2010 may include one or more software modules. Optionally, the processor 2001 may also store program code or instructions for executing the solutions of this application.

In a specific embodiment, the computer system 2000 in this embodiment of this application may include the first module in the foregoing method embodiments. The processor 2001 in the computer system 2000 reads the program code 2010 in the memory 2003 or the program code or the instructions stored in the processor 2001, to cause the computer system 2000 shown in FIG. 8 to perform all or some of the operations performed by the first module.

In a specific embodiment, the computer system 2000 in this embodiment of this application may include the second module in the foregoing method embodiments. The processor 2001 in the computer system 2000 reads the program code 2010 in the memory 2003 or the program code or the instructions stored in the processor 2001, to cause the computer system 2000 shown in FIG. 8 to perform all or some of the operations performed by the second module.

The computer system 2000 may further correspond to the apparatuses shown in FIG. 6 and FIG. 7. Each functional unit in the apparatuses shown in FIG. 6 and FIG. 7 is implemented by using software of the computer system 2000. In other words, the functional units included in the apparatuses shown in FIG. 6 and FIG. 7 are generated after the processor 2001 of the computer system 2000 reads the program code 2010 stored in the memory 2003.

The steps in the alignment marker search methods shown in FIG. 2 are completed by using an integrated logic circuit of hardware in the processor of the computer system 2000 or by using instructions in a form of software. The steps of the methods disclosed with reference to embodiments of this application may be directly performed by a hardware processor, or may be performed by using a combination of hardware in the processor and a software module. The software module may be located in a mature storage medium in the art, for example, a random access memory, a flash memory, a read-only memory, a programmable read-only memory, an electrically erasable programmable memory, or a register. The storage medium is located in the memory, and the processor reads information in the memory and completes the steps in the foregoing methods in combination with hardware of the processor. To avoid repetition, details are not described herein again.

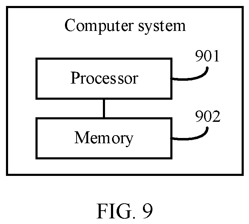

FIG. 9 is a diagram of a structure of another computer system according to an embodiment of this application. The computer system is configured to perform the operations related to the first module or the second module in the alignment marker search method shown in FIG. 2. For example, the computer system is a server. The server may vary greatly due to different configurations or performance. The computer system may include one or more processors 901 and one or more memories 902. The one or more memories 902 store at least one computer program, and the at least one computer program is loaded and executed by the one or more processors 901. For example, the processor 901 is a CPU. Certainly, the computer system may further include components such as a wired or wireless network interface, a keyboard, and an input/output interface, to perform input/output. The computer system may further include another component configured to implement a device function. Details are not described herein.

An embodiment of this application further provides a computer system. The computer system includes a processor. The processor includes a first module or a second module. The processor is configured to invoke, from a memory, instructions stored in the memory and run the instructions. When the processor includes the first module, the computer system implements the alignment marker search method performed by the first module. When the processor includes the second module, the computer system implements the alignment marker search method performed by the second module.

In a possible implementation, the computer system further includes an input interface, an output interface, and the memory. The input interface, the output interface, the processor, and the memory are connected through an internal connection path.

An embodiment of this application further provides a communication system. The communication system includes a first module and a second module. The first module is configured to perform the method performed by the first module shown in FIG. 2, and the second module is configured to perform the method performed by the second module shown in FIG. 2. For functions of the first module and the second module of the communication system, refer to the related descriptions shown in FIG. 2. Details are not described herein again.

An embodiment of this application further provides a communication apparatus. The apparatus includes a transceiver, a memory, and a processor. The transceiver, the memory, and the processor communicate with each other through an internal connection path. The memory is configured to store instructions. The processor is configured to execute the instructions stored in the memory, to control the transceiver to receive/send a signal. The processor includes a first module or a second module. If the processor includes the first module, when the processor executes the instructions stored in the memory, the processor is caused to perform the alignment marker search method performed by the first module. If the processor includes the second module, when the processor executes the instructions stored in the memory, the processor is caused to perform the alignment marker search method performed by the second module.

It should be understood that the processor may be a CPU, or may be another general-purpose processor, a DSP, an ASIC, an FPGA or another programmable logic device, a discrete gate or a transistor logic device, a discrete hardware component, or the like. The general-purpose processor may be a microprocessor, any conventional processor, or the like. It should be noted that the processor may be a processor that supports an advanced reduced instruction set computer machine (advanced RISC machine, ARM) architecture.

Further, in an optional embodiment, the memory may include a read-only memory and a random access memory, and provide instructions and data for the processor. The memory may further include a non-volatile random access memory. For example, the memory may further store information about a device type.

The memory may be a volatile memory or a non-volatile memory, or may include both a volatile memory and a non-volatile memory. The non-volatile memory may be a ROM, a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a RAM, and is used as an external cache. By way of example, and not limitation, many forms of RAMs are available, for example, a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

An embodiment of this application further provides a computer-readable storage medium. The computer-readable storage medium stores at least one program instruction or code, the program instruction or the code is executed by a computer, and the computer includes a first module or a second module. If the computer includes the first module, when the program instruction or the code is executed by the computer, the computer is caused to implement the alignment marker search method performed by the first module. If the computer includes the second module, when the program instruction or the code is executed by the computer, the computer is caused to implement the alignment marker search method performed by the second module.

An embodiment of this application further provides a computer program product. The computer program product includes computer program instructions or code, the computer program instructions or the code is run by a computer, and the computer includes a first module or a second module. If the computer includes the first module, when the computer program instructions or the code is run by the computer, the computer is caused to perform the alignment marker search method performed by the first module. If the computer includes the second module, when the computer program instructions or the code is run by the computer, the computer is caused to perform the alignment marker search method performed by the second module.

An embodiment of this application further provides a chip, including a processor. The processor includes a first module or a second module. The processor is configured to run program instructions or code. If the processor includes the first module, a device including the chip performs the alignment marker search method performed by the first module. If the processor includes the second module, a device including the chip performs the alignment marker search method performed by the second module.

For example, the chip further includes an input interface, an output interface, and a memory. The input interface, the output interface, the processor, and the memory are connected through an internal connection path, and the memory includes the program instructions or the code.

All or some of the foregoing embodiments may be implemented by using software, hardware, firmware, or any combination thereof. When software is used to implement the embodiments, all or some of the embodiments may be implemented in a form of a computer program product. The computer program product includes one or more computer instructions. When computer program instructions are loaded and executed on a computer, all or some of the procedures or functions according to this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, microwave, or the like) manner. The computer-readable storage medium may be any usable medium accessible by the computer, or a data storage device such as a server or a data center, integrating one or more usable media. The usable medium may be a magnetic medium (for example, a floppy disk, a hard disk, or a magnetic tape), an optical medium (for example, a digital video disc (digital video disc, DVD)), or a semiconductor medium (for example, a solid-state drive (solid-state drive, SSD)), or the like.

In the foregoing embodiments, a unit of a transmission rate is Gb/s, and may also be referred to as G for short. For example, a rate 400 Gb/s may also be referred to as 400 G for short.

To clearly describe the interchangeability of hardware and software, the steps and composition of embodiments have been generally described in the foregoing descriptions in terms of functions. Whether the functions are performed by hardware or software depends on particular applications and design constraint conditions of the technical solutions. A person of ordinary skill in the art may use different methods to implement the described functions for each particular application, but it should not be considered that the implementation goes beyond the scope of this application.

Computer program code used to implement the methods in embodiments of this application may be written in one or more programming languages. The computer program code may be provided for a processor of a general-purpose computer, a dedicated computer, or another programmable alignment marker search apparatus, so that when the program code is executed by the computer or the another programmable alignment marker search apparatus, functions/operations specified in the flowcharts and/or block diagrams are implemented. The program code may be executed entirely on a computer, partly on a computer, as a standalone software package, partly on a computer and partly on a remote computer, or entirely on a remote computer or a server.

In the context of embodiments of this application, computer program code or related data may be carried in any appropriate carrier, so that the device, the apparatus, or the processor can perform various types of processing and operations described above. Examples of the carrier include a signal, a computer-readable medium, and the like. Examples of the signal may include an electrical signal, an optical signal, a radio signal, a voice signal, or other forms of propagated signals, such as a carrier wave and an infrared signal.

It can be clearly understood by a person skilled in the art that, for the purpose of convenient and brief description, for a detailed working process of the foregoing system, device, and module, refer to a corresponding process in the foregoing method embodiments. Details are not described herein again.

In the several embodiments provided in this application, it should be understood that the disclosed system, device, and method may be implemented in other manners. For example, the described device embodiment is merely an example. For example, division of modules is merely division of logical functions and there may be other division modes during actual application. For example, a plurality of modules or components may be combined or may be integrated to another system, or some characteristics may be ignored or not executed. In addition, the displayed or discussed mutual couplings or direct couplings or communication connections may be indirect couplings or communication connections implemented by some interfaces, devices, or modules, or may be electrical, mechanical, or other forms of connection.

The modules described as separate parts may or may not be physically separate, and parts displayed as modules may or may not be physical modules, to be specific, may be located at one position, or may be distributed on a plurality of network modules. Some or all of the modules may be selected based on actual requirements to implement the objectives of the solutions of embodiments of this application.

In addition, functional modules in embodiments of this application may be integrated into one processing module, or each of the modules may exist alone physically, or two or more modules may be integrated into one module. The integrated module may be implemented in a form of hardware, or may be implemented in a form of a software functional module.

In this application, terms such as "first" and "second" are used to distinguish between same items or similar items that have basically same functions. It should be understood that there is no logical or time sequence dependency between "first", "second", and "n^{th}", and a quantity and an execution sequence are not limited. It should be further understood that although the following descriptions use terms such as "first" and "second" to describe various elements, these elements should not be limited by the terms. These terms are simply used to distinguish one element from another. For example, a first module may be referred to as a second module without departing from the scope of the various described examples, and similarly, a second module may be referred to as a first module.

It should be further understood that, in embodiments of this application, sequence numbers of the processes do not mean execution sequences. The execution sequences of the processes should be determined based on functions and internal logic of the processes, and should not be construed as any limitation on implementation processes of embodiments of this application.

In this application, the term "at least one" means one or more, and the term "a plurality of" in this application means two or more. For example, a plurality of code blocks means two or more code blocks. The terms "system" and "network" are often used interchangeably herein.

It should be understood that the terms used in the descriptions of various examples in this specification are merely intended to describe specific examples but are not intended to constitute a limitation. The terms "one" ("a" and "an") and "the" of singular forms used in the descriptions of the various examples and the appended claims are also intended to include plural forms, unless otherwise specified in the context clearly.

It should further be understood that the term "include" (also referred to as "includes", "including", "comprises", and/or "comprising") used in this specification specifies presence of the stated features, integers, steps, operations, elements, and/or components, with presence or addition of one or more other features, integers, steps, operations, elements, components, and/or their components not excluded.

It should also be understood that, depending on the context, the phrase "if it is determined..." or "if [a stated condition or event] is detected" may be interpreted to mean "once determining" or "in response to determining ..." or "once detecting [the stated condition or event] "or "in response to the detection of [the stated condition or event]".

It should be understood that determining B based on A does not mean that B is determined based only on A, and B may alternatively be determined based on A and/or other information.

It should be further understood that "an embodiment", "an embodiment", and "a possible implementation" mentioned throughout the specification mean that a specific feature, structure, or characteristic related to the embodiment or an implementation is included in at least one embodiment of this application. Therefore, "in one embodiment" or "in an embodiment" or "a possible implementation" appearing throughout the specification may not necessarily refer to a same embodiment. In addition, these particular features, structures, or characteristics may be combined in one or more embodiments in any appropriate manner.

## Claims

1. An alignment marker search method, wherein the method comprises:
receiving, by a first module, a first data stream transmitted by a second module, wherein the first data stream is obtained by multiplexing a plurality of second data streams at a reference granularity, any second data stream comprises an alignment marker AM and data from at least one forward error correction FEC codeword, the reference granularity is a quantity of bits corresponding to n symbols comprised in the FEC codeword, and n is a positive integer;
obtaining a first data segment from a first location in the first data stream at the reference granularity, wherein the first location is any location in the first data stream; and
performing AM search on the first data segment.

2. The method according to claim 1, wherein obtaining the first data segment from the first location in the first data stream at the reference granularity comprises:
demultiplexing the first data stream from the first location in the first data stream at the reference granularity, to obtain the first data segment.

3. The method according to claim 1, wherein obtaining the first data segment from the first location in the first data stream at the reference granularity comprises:
obtaining a first quantity of bits at an interval of first quantity of bits from the first location in the first data stream, and obtaining the first data segment based on a plurality of groups of first quantity of bits that are obtained, wherein the first quantity is determined based on the reference granularity.

4. The method according to any one of claims 1 to 3, wherein the method further comprises:
obtaining a second data segment from a second location in the first data stream at the reference granularity based on no AM being found in the first data segment, wherein the second location is different from the first location; and
performing AM search on the second data segment.

5. The method according to claim 4, wherein the second location is a location after the first location by a second quantity of bits, or the second location is a location after the first location by a third quantity of reference symbols, wherein
a type of the reference symbol is determined based on a modulation scheme corresponding to the second data stream, and the second quantity is different from a quantity of bits corresponding to the third quantity of reference symbols.

6. The method according to any one of claims 1 to 5, wherein the AM comprises a common marker CM field, and the CM field is used to perform AM search on the first data segment.

7. The method according to any one of claims 1 to 6, wherein the FEC codeword is a Reed-Solomon RS codeword.

8. An alignment marker search method, wherein the method comprises:
obtaining, by a second module, a first data stream, wherein the first data stream is obtained by multiplexing a plurality of second data streams at a reference granularity, any second data stream comprises an alignment marker AM and data from at least one forward error correction FEC codeword, the reference granularity is a quantity of bits corresponding to n symbols comprised in the FEC codeword, and n is a positive integer; and
transmitting the first data stream to a first module, to cause the first module to obtain a first data segment from a first location in the first data stream at the reference granularity, wherein the first location is any location in the first data stream, and to perform AM search on the first data segment.

9. An alignment marker search apparatus, wherein the apparatus is used in a first module, and the apparatus comprises:
an obtaining unit, configured to receive a first data stream transmitted by a second module, wherein the first data stream is obtained by multiplexing a plurality of second data streams at a reference granularity, any second data stream comprises an alignment marker AM and data from at least one forward error correction FEC codeword, the reference granularity is a quantity of bits corresponding to n symbols comprised in the FEC codeword, and n is a positive integer, wherein
the obtaining unit is further configured to obtain a first data segment from a first location in the first data stream at the reference granularity, wherein the first location is any location in the first data stream; and
a search unit, configured to perform AM search on the first data segment.

10. The apparatus according to claim 9, wherein the obtaining unit is configured to demultiplex the first data stream from the first location in the first data stream at the reference granularity, to obtain the first data segment.

11. The apparatus according to claim 9, wherein the obtaining unit is configured to: obtain a first quantity of bits at an interval of first quantity of bits from the first location in the first data stream, and obtain the first data segment based on a plurality of groups of first quantity of bits that are obtained, wherein the first quantity is determined based on the reference granularity.

12. The apparatus according to any one of claims 9 to 11, wherein the search unit is further configured to: obtain a second data segment from a second location in the first data stream at the reference granularity based on no AM being found in the first data segment, wherein the second location is different from the first location; and perform AM search on the second data segment.

13. The apparatus according to claim 12, wherein the second location is a location after the first location by a second quantity of bits, or the second location is a location after the first location by a third quantity of reference symbols, wherein a type of the reference symbol is determined based on a modulation scheme corresponding to the second data stream, and the second quantity is different from a quantity of bits corresponding to the third quantity of reference symbols.

14. The apparatus according to any one of claims 9 to 13, wherein the AM comprises a common marker CM field, and the CM field is used to perform AM search on the first data segment.

15. The apparatus according to any one of claims 9 to 14, wherein the FEC codeword is a Reed-Solomon RS codeword.

16. An alignment marker search apparatus, wherein the apparatus is used in a second module, and the apparatus comprises:
an obtaining unit, configured to obtain a first data stream, wherein the first data stream is obtained by multiplexing a plurality of second data streams at a reference granularity, any second data stream comprises an alignment marker AM and data from at least one forward error correction FEC codeword, the reference granularity is a quantity of bits corresponding to n symbols comprised in the FEC codeword, and n is a positive integer; and
a transmission unit, configured to: transmit the first data stream to a first module, to cause the first module to obtain a first data segment from a first location in the first data stream at the reference granularity, wherein the first location is any location in the first data stream, and to perform AM search on the first data segment.

17. A communication system, wherein the system comprises a first module and a second module, the first module is configured to perform the method according to any one of claims 1 to 7, and the second module is configured to perform the method according to claim 8.

18. A computer system, wherein the computer system comprises a processor, the processor comprises a first module or a second module, and if the processor comprises the first module, when the processor executes program instructions or code, the computer system implements the method according to any one of claims 1 to 7, or if the processor comprises the second module, when the processor executes program instructions or code, the computer system implements the method according to claim 8.

19. The computer system according to claim 18, wherein the computer system further comprises a memory, and the memory is configured to store the program instructions or the code.

20. A computer-readable storage medium, wherein the computer-readable storage medium stores at least one program instruction or code, the program instruction or the code is executed by a computer, the computer comprises a first module or a second module, and if the computer comprises the first module, when the program instruction or the code is executed by the computer, the computer is caused to implement the method according to any one of claims 1 to 7, or if the computer comprises the second module, when the program instruction or the code is executed by the computer, the computer is caused to implement the method according to claim 8.

21. A computer program product, wherein the computer program product comprises computer program instructions or code, the computer program instructions or the code is run by a computer, the computer comprises a first module or a second module, and if the computer comprises the first module, when the computer program instructions or the code is run by the computer, the computer is caused to implement the method according to any one of claims 1 to 7, or if the computer comprises the second module, when the computer program instructions or the code is run by the computer, the computer is caused to implement the method according to claim 8.

22. A chip, wherein the chip comprises a processor, the processor comprises a first module or a second module, the processor is configured to run program instructions or code, and if the processor comprises the first module, a device comprising the chip performs the method according to any one of claims 1 to 7, or if the processor comprises the second module, a device comprising the chip performs the method according to claim 8.

23. The chip according to claim 22, wherein the chip further comprises an input interface, an output interface, and a memory, the input interface, the output interface, the processor, and the memory are connected through an internal connection path; and the memory comprises the program instructions or the code.
